# EUROPEAN PATENT APPLICATION

(11) **EP 2 432 027 A2**
(43) Date of publication of application: **21.03.2012**
(21) Application number: 10769959.7
(22) Date of filing: 29.04.2010
(51) Int. Cl.: H01L 31/042, B82B 1/00

(54) **SILICON SOLAR CELL COMPRISING A CARBON NANOTUBE LAYER**

(30) Priority: 30.04.2009 KR 20090038062
(71) Applicant: Industry-University Cooperation Foundation Hanyang University, Seoul 133-791 (KR)
(72) Inventor: YI, Whi-Kun, Seoul 137-775 (KR); LEE, Jung-Woo, Seoul 121-809 (KR)
(74) Representative: Zimmermann, Tankred Klaus
(86) International application number: PCT/KR2010/002707
(87) International publication number: WO 2010/126314

(57) **Abstract**

A silicon solar cell including a carbon nanotube layer is provided. The carbon nanotube layer is disposed on at least one of front and back surfaces of a p-n junction silicon substrate which includes a p-type silicon layer and an n-type silicon layer, Accordingly, the intensity of the electric field applied to devices may be increased due to introduction of the carbon nanotube layer, resulting in improved photoelectric conversion efficiency.

## Description

### CLAIM FOR PRIORITY

This application claims priority to Korean Patent Application No. 2009-0038062 filed on April 30, 2009 in the Korean Intellectual Property Office (KIPO), the entire contents of which are hereby incorporated by reference.

### BACKGROUND

### 1. Technical Field

Example embodiments of the present invention relate in general to a silicon solar cell, and more specifically, to a silicon solar cell including a carbon nanotube layer disposed on at least one surface of front and back surfaces of a p-n junction silicon substrate.

### 2. Related Art

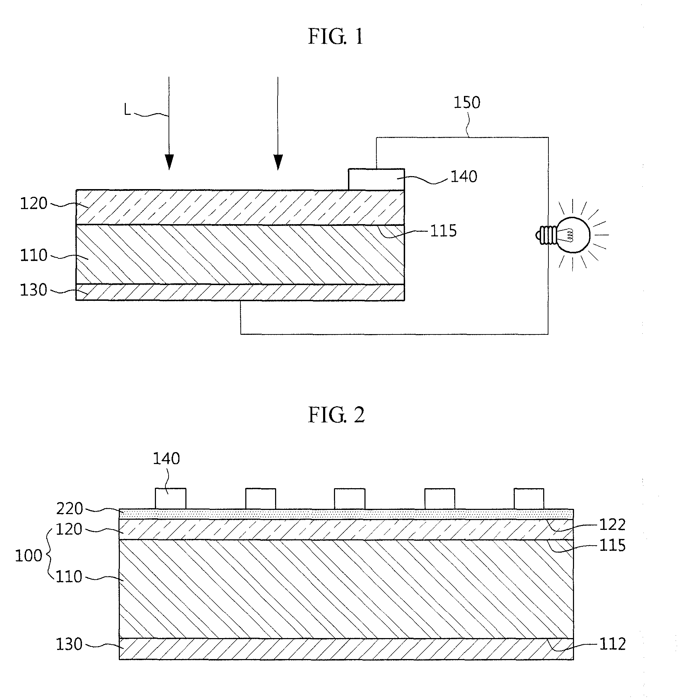

Much interest has been taken in development of clean alternative energy sources so as to solve environmental issues and problems of high oil prices, and so there has been much research into development of a solar cell (or a photovoltaic cell). The solar cell is a semiconductor device that directly converts solar energy into electrical energy using a photovoltaic effect, and has a basic structure as shown in FIG. 1

Referring to FIG. 1, like a diode, a solar cell has a junction structure of a p-type semiconductor 110 and an n-type semiconductor 120. When light (L) is incident onto the solar cell, electrons having negative (-) charges and holes having positive (+) charges due to emission of electrons are generated by interaction of the incident light with a material constituting a semiconductor of the solar cell, and current flows by movement of the electrons and the holes. This is called a photovoltaic effect. In this case, the electrons and the holes are respectively attracted toward the n-type semiconductor 120 and the p-type semiconductor 110 by an electric field formed around the p-n junction 115, and travel to electrodes 140 and 130, which have junctions with the n-type semiconductor 120 and the p-type semiconductor 110, respectively. Then, current flows through an external circuit 150 connected to the electrodes 140 and 130.

Solar cells driven based on the above-described principle are mainly divided into two categories: a silicon solar cell and a compound semiconductor solar cell. However, the solar cells have many problems regarding poor photoelectric conversion efficiency. Therefore, there has been much research conducted in order to improve the photoelectric conversion efficiency of silicon solar cells. For example, in an article [J. Non-crystal. Solids, 354, 19 (2008) Vacuum, 80, 1090 (2006); Science, 285, 692 (1999)], it was disclosed that the reflexibility is reduced using a concavo-convex structure and an antireflective film, or the recombination of minority carriers is suppressed through changes in heat treatment conditions to improve the efficiency of solar cells. However, the photoelectric conversion efficiency is not significantly improved due to the presence of problems yet to be solved, including electron-hole recombination, recombination rate, contact resistance, and the like.

### SUMMARY

Accordingly, example embodiments of the present invention are provided to substantially obviate one or more problems due to limitations and disadvantages of the related art.

Example embodiments of the present invention provide a silicon solar cell whose photoelectric conversion efficiency is improved due to introduction of a carbon nanotube layer.

In some example embodiments, a silicon solar cell comprises a p-n junction silicon substrate including a p-type silicon layer and an n-type silicon layer, a carbon nanotube layer disposed on a front or back surface of the silicon substrate, and a first electrode disposed on a surface of the silicon substrate on which the carbon nanotube layer is not disposed.

The silicon solar cell may further comprise a second electrode disposed on the carbon nanotube layer.

Also, the surface of the silicon substrate on which the carbon nanotube layer is disposed may have a concavo-convex structure.

In other example embodiments, a silicon solar cell comprises a p-n junction silicon substrate including a p-type silicon layer and an n-type silicon layer, and carbon nanotube layers disposed on front and back surfaces of the silicon substrate.

The silicon solar cell may further comprise an electrode disposed on at least one of the carbon nanotube layers disposed on the front and back surfaces of the silicon substrate.

Also, at least one of the front and back surfaces of the silicon substrate may have a concavo-convex structure.

### BRIEF DESCRIPTION OF DRAWINGS

Example embodiments of the present invention will become more apparent by describing in detail example embodiments of the present invention with reference to the accompanying drawings, in which:
FIG 1 is a cross-sectional view illustrating a basic structure of a solar cell.
FIG. 2 is a cross-sectional view illustrating a silicon solar cell in which a carbon nanotube layer is disposed on a front surface of a p-n junction silicon substrate.
FIG. 3 is a cross-sectional view illustrating a silicon solar cell in which a carbon nanotube layer is disposed on a back surface of a p-n junction silicon substrate.
FIG. 4 is a schematic view illustrating a carbon nanotube layer disposed on a surface of a p-n junction silicon substrate having (a) a flat structure or (b) a concavo-convex structure.
FIG 5 is a cross-sectional view illustrating a silicon solar cell in which carbon nanotube layers are disposed on front and back surfaces of a p-n junction silicon substrate.
FIG. 6 is a cross-sectional view illustrating a silicon solar cell which does not include a carbon nanotube layer produced in Comparative Example 1.
FIG. 7 is a graph illustrating the photoelectric conversion efficiency of the silicon solar cell which does not include the carbon nanotube layer produced in Comparative Example 1.
FIGS, 8 to 10 are graphs illustrating the photoelectric conversion efficiencies of silicon solar cells which do not include carbon nanotube layers produced in Preparative Examples 1 to 3, respectively.
FIGS. 11 and 12 are cross-sectional views illustrating silicon solar cells produced in Preparative Examples 4 and 5, respectively.
FIG. 13 is a cross-sectional view illustrating a silicon solar cell produced in Comparative Example 2.
FIG. 14 is a graph illustrating the photoelectric conversion efficiencies of the silicon solar cells produced in Preparative Examples 4 and 5 and Comparative Example 2.
FIG. 15 is a cross-sectional view illustrating a silicon solar cell produced in Preparative Example 6.
FIG 16 is a graph illustrating the photoelectric conversion efficiency of the silicon solar cell produced in Preparative Example 6.

### DESCRIPTION OF EXAMPLE EMBODIMENTS

Example embodiments of the present invention are disclosed herein. However, specific structural and functional details disclosed herein are merely representative for purposes of describing example embodiments of the present invention, however, example embodiments of the present invention may be embodied in many alternate forms and should not be construed as limited to example embodiments of the present invention set forth herein.

Accordingly, while the invention is susceptible to various modifications and alternative forms, specific embodiments thereof are shown by way of example in the drawings and will herein be described in detail. It should be understood, however, that there is no intent to limit the invention to the particular forms disposed, but on the contrary, the invention is to cover all modifications, equivalents, and alternatives falling within the spirit and scope of the invention. Like numbers refer to like elements throughout the description of the figures.

It will be understood that, although the terms first, second, etc. may be used herein to describe various elements, these elements should not be limited by these terms. These terms are only used to distinguish one element from another, For example, a first element could be termed a second element, and, similarly, a second element could be termed a first element, without departing from the scope of the present invention.

The terminology used herein is for the purpose of describing particular embodiments only and is not intended to be limiting of the invention, As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

A silicon solar cell according to example embodiments of the present invention comprises a p-n junction silicon substrate including a p-type silicon layer and an n-type silicon layer, a carbon nanotube layer disposed on a front or back surface of the silicon substrate, a first electrode disposed on a surface of the silicon substrate in which the carbon nanotube layer is not disposed, and a second electrode disposed on the carbon nanotube layer. However, it is possible to omit the second electrode disposed on the carbon nanotube layer.

Also, the silicon solar cell may have a concavo-convex structure formed at a surface of the silicon substrate in which the carbon nanotube layer is disposed.

FIG. 2 is a cross-sectional view illustrating a silicon solar cell in which a carbon nanotube layer is disposed on a front surface of a p-n junction silicon substrate.

Referring to FIG. 2, the silicon solar cell comprises a p-n junction silicon substrate 100 including a p-type silicon layer 110 and an n-type silicon layer 120, a carbon nanotube layer 220 disposed on a front surface 122 (*i*.*e*., a surface of the n-type silicon layer) of the silicon substrate 100, a back electrode 130 disposed on a back surface 112 of the silicon substrate 100, and a front electrode 140 disposed on the carbon nanotube layer 220. However, the front electrode 140 may be omitted.

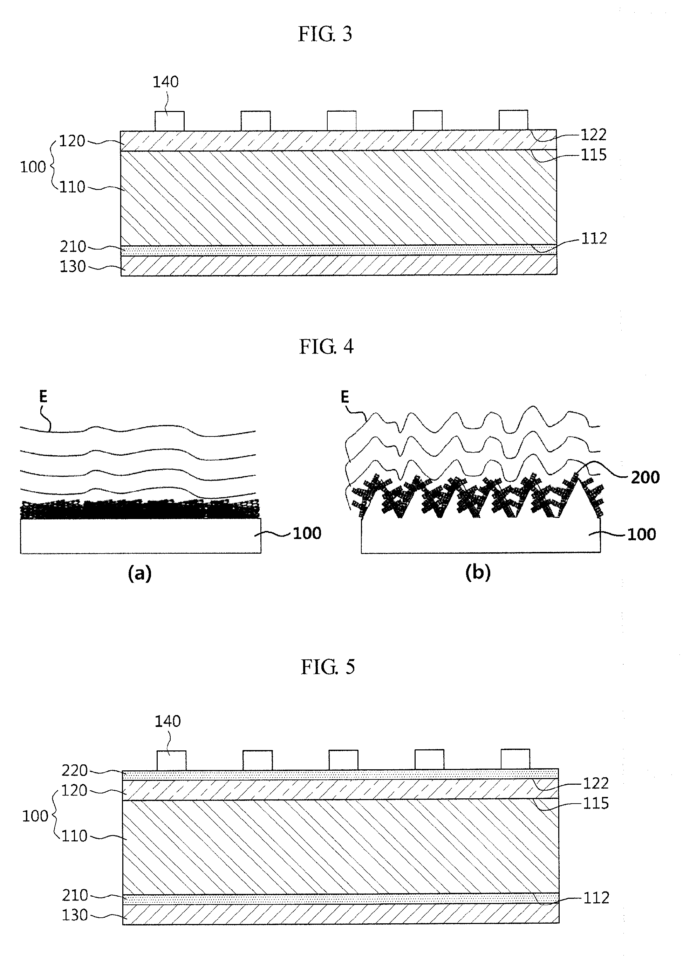

FIG. 3 is a cross-sectional view illustrating a silicon solar cell in which a carbon nanotube layer is disposed on a back surface of a p-n junction silicon substrate.

Referring to FIG. 3, the silicon solar cell comprises a p-n junction silicon substrate 100 including a p-type silicon layer 110 and an n-type silicon layer 120, a carbon nanotube layer 210 disposed on a back surface 112 (*i*.*e*., a surface of the p-type silicon layer) of the silicon substrate 100, a front electrode 140 disposed on a front surface 122 of the silicon substrate 100, and a back electrode 130 disposed on the carbon nanotube layer 210. However, the back electrode 130 may be omitted.

As shown in FIGS. 2 and 3, the p-n junction silicon substrate 100 has a p-n junction 115 formed between the p-type silicon layer 110 and the n-type silicon layer 120, and serves to receive light and generate current using a photovoltaic effect. The p-type silicon layer 110 may be a silicon layer doped with Group-III elements such as boron (B), gallium (Ga) and indium (In), and the n-type silicon layer 120 may be a silicon layer doped with Group-V elements such as phosphorus (P), arsenic (As) and antimony (Sb).

The p-n junction silicon substrate 100 may be formed by coating an n-type dopant such as a Group-V element on a p-type silicon substrate and diffusing the n-type dopant into the p-type silicon substrate using a heat-treatment process. Meanwhile, the p-n junction silicon substrate 100 may be formed by an ion doping process using plasma, or may be formed by stacking a p-type emitter silicon layer on an n-type silicon substrate. However, the present invention is not limited thereto.

There is no particular limit to thicknesses of the carbon nanotube layers 220 and 210 disposed on the front and back surface 122 and 112 of the p-n junction silicon substrate 100. However, the carbon nanotube layer 220 disposed on the front surface 122 onto which sunlight is incident may be preferably formed at a thickness of approximately 200 nm or less. This is because, when the thickness of the carbon nanotube layer 220 disposed on the front surface 122 of the p-n junction silicon substrate 100 exceeds 200 nm, it is possible to prevent some sunlight from penetrating into the p-n junction silicon substarate 100.

Carbon nanotubes used to form the carbon nanotube layers 220 and 210 are not particularly limited, and may include carbon nanotubes such as a single-walled carbon nanotube and a multiwall carbon nanotube, as known in the art.

The carbon nanotube layers 220 and 210 may be formed using a spray method or a paste screen printing method. However, the present invention is not limited thereto. Preferably, the carbon nanotube layers 220 and 210 may be formed using a spray method. The spray method has an advantage in that the carbon nanotube layers 220 and 210 may be easily formed by dispersing carbon nanotubes in a solvent such as ethanol to prepare a dispersion solution, spraying the dispersion solution on the p-n junction silicon substrate 100 and heat-treating the p-n junction silicon substrate 100 as a subsequent process (for example, at a temperature of approximately 80 °C).

When the carbon nanotube layers 220 and 210 are formed on the p-n junction silicon substrate 100 as described above, the carbon nanotube layers are formed as a network thin film having in-plane conductivity, and the intensity of an electric field applied to the device may be increased, Therefore, it is possible to reduce an electron-hole recombination level and a recombination rate, thereby improving the photoelectric conversion efficiency. Also, since carbon nanotubes generally have similar properties to the p-type semiconductor, a new p-n junction may be formed when a carbon nanotube layer is disposed on the n-type silicon layer, thereby realizing a multiple exciton generation (MEG) effect. In addition, when a carbon nanotube layer is disposed on the p-type silicon layer, a back surface field (BSF) effect may be achieved by the presence of the carbon nanotube layer itself. Therefore, a BSF-forming procedure (as will be described later) through deposition and high-temperature heat treatment of a back electrode (especially, an Al electrode) may be omitted.

Further, a surface of the p-n junction silicon substrate 100 on which the carbon nanotube layers 220 and 210 are disposed may have a concavo-convex structure.

FIG. 4 is a schematic view illustrating a carbon nanotube layer disposed on a surface of a p-n junction silicon substrate 100 having (a) a flat structure or (b) a concavo-convex structure.

Referring to FIG. 4, when a concavo-convex structure (b) is formed on the surface of the p-n junction silicon substrate 100, an amount of carbon nanotubes 200 arranged substantially vertically with respect to a p-n junction interface in the silicon substrate 100 may be increased in addition to increased light absorptance in a light-receiving surface. In this case, as seen from an equipotential surface (E) shown in FIG. 4, the intensity applied to the device may be further increased, which contributes to improving the photoelectric conversion efficiency. A texturing process of forming the concavo-convex structure is not particularly limited, and may be performed through a wet etching method using a base or acid solution, or a dry etching method using plasma.

Meanwhile, when the formation of the concavo-convex structure is not performed, the vertical orientation of carbon nanotubes in the carbon nanotube layers 220 and 210 may be enhanced using a tapping or rubbing method. Here, the tapping method is performed by forming the carbon nanotube layers 220 and 210 and attaching and detaching the carbon nanotube layers 220 and 210 with an adhesive tape, and the rubbing method is performed by rubbing the carbon nanotube layers 220 and 210 with a rubbing roller.

Referring again to FIGS. 2 and 3, the front electrode 140 may contain a metal such as gold (Au), silver (Ag), palladium (Pd)/Ag, or titanium (Ti)/Au. The front electrode 140 may be, for example, formed by coating an electrode-forming paste containing Ag or Au along a predetermined pattern and subjecting a heat-treatment process, or may be formed by depositing a metal such as Ti/Au, which may be used as the front electrode, through a sputtering method using a patterned chrome mask. However, when the carbon nanotube layer 220 is disposed on the front surface 122 of the p-n junction silicon substrate 100, the front electrode 140 may be omitted. In this case, the carbon nanotube layer 220 having excellent light transmission and electric conductivity may function on behalf of the front electrode 140.

The back electrode 130 may, for example, include at least one metal selected from the group consisting of copper (Cu), tungsten (W), iron (Fe), aluminum (Al), carbon (C), Ag, nickel (Ni), Ti and titanium nitride (TiN). Preferably, an aluminum electrode may be used as the back electrode 130. This is because a junction with the aluminum electrode is easily formed since the aluminum electrode has excellent conductivity and good affinity to silicon. Also, the aluminum electrode is made of a trivalent element, and may form a P⁺ layer, that is, a back surface field (BSF, not shown) on a junction surface with the back surface 112 of the silicon substrate 100 using a high-temperature heat treatment process. The back surface field may serve to prevent electrons excited by sunlight from traveling from an inner part to a back surface of the silicon substrate 100 and being recombined with holes, thereby reducing a leakage current and improving the efficiency of solar cells,

The back electrode 130 may be formed by coating an electrode-forming paste containing a metal such as Al along a predetermined pattern and subjecting a heat-treatment process. However, when the carbon nanotube layer 210 is formed on the back surface 112 of the silicon substrate 100, the back electrode 130 may also be omitted. In this case, a BSF effect may be achieved by the presence of the carbon nanotube layer 210 itself, as described above.

The silicon solar cell according to other example embodiments of the present invention comprises a p-n junction silicon substrate including a p-type silicon layer and an n-type silicon layer, carbon nanotube layers disposed on front and back surfaces of the silicon substrate, and electrodes disposed on the carbon nanotube layers disposed on the front and back surfaces of the silicon substrate. However, at least one of the electrodes disposed on the carbon nanotube layers may be omitted.

Also, the silicon solar cell may have a concavo-convex structure on at least one of the front and back surfaces of the silicon substrate.

FIG. 5 is a cross-sectional view illustrating a silicon solar cell in which carbon nanotube layers are disposed on front and back surfaces of a p-n junction silicon substrate.

Referring to FIG. 5, the silicon solar cell according to these example embodiments comprises a p-n junction silicon substrate 100 including a p-type silicon layer 110 and an n-type silicon layer 120, carbon nanotube layers 220 and 210 disposed respectively on front and back surfaces 122 and 112 of the silicon substrate 100, and front and back electrodes 140 and 130 disposed respectively on the carbon nanotube layers 220 and 210. However, at least one of the front and back electrodes 140 and 130 disposed respectively on the carbon nanotube layers 220 and 210 may be omitted.

The constituent and production method of the silicon solar cell as shown in FIG. 5 are described with reference to FIGS. 2 and 3, and are identical to those described above, except that the carbon nanotube layers 220 and 210 are formed on the front and back surfaces 122 and 112 of the silicon substrate 100.

Also, at least one of the front and back surfaces 122 and 112 of the silicon substrate 100 may have a concavo-convex structure, and the concavo-convex structure is recited in the example embodiments described with reference to FIG. 4.

Hereinafter, preferred examples are provided to promote better understanding of the present invention. However, it should be understood that the following examples of the present invention are given for the purpose of illustration only, not intended to limit the scope of the present invention.

### <Preparative Example 1>

A commercially available p-type silicon wafer (LG Siltron, Inc., Korea; specific resistance: 1 to 5 Ωcm, thickness: 500 ± 5 um, doping density: 4.5 × 10¹⁶ ions/cm³, and orientation: 100) was washed using a standard RCA washing process. The standard RCA washing process includes a Standard Clean-1 (SC1) process and a Standard Clean-2 (SC2) process. First, the SC1 process was performed (in a washing solution (NH₄OH:H₂O₂:DI-water = 1:1:5) at 70 °C for 5 minutes) to remove metals and organic remnants on a silicon wafer, and the SC2 process was performed (in a washing solution (HCl:H₂O₂:DI-water = 1:1:5) at 70 °C for 5 minutes) to remove metals on the silicon wafer. Then, the p-type silicon wafer was subjected to a WET cleaning process, such as SPM (sulfuric acid peroxide mixture or piranha solution) treatment and HF treatment.

Next, a POCl₃ diffusion process of forming a p-n junction (at a temperature of 950 °C for a predeposition time of 10 minutes and then 30 additional minutes) was performed (the silicon wafer had a surface resistance changed from 20 to 200 Ω/sq to 40 Ω/sq, and a doping density of approximately 2 x 10¹⁹ ions/cm³ after the diffusion process).

A solution obtained by dissolving carbon nanotubes in ethanol was sprayed on a front surface (*i*.*e*., a surface of the n-type silicon layer) of a p-n junction silicon substrate obtained by forming a p-n junction using the POCl₃ diffusion process, thereby forming a carbon nanotube layer having a thickness of 1 nm to 200 nm. Then, a front electrode containing Ti/Au was formed on the carbon nanotube layer, which had been formed on the front surface of the p-n junction silicon substrate, using a sputtering method, such that Ti had a thickness of 50 nm and Au had a thickness of 4 nm.

Thereafter, a back electrode containing Al was formed at a thickness of 200 nm on the back surface (*i*.*e*., a surface of the p-type silicon layer) of the p-n junction silicon substrate using a sputtering method, and a BSF layer was formed by performing an RTA process (at 850 °C) using a halogen lamp.

### <Preparative Example 2>

A silicon solar cell was produced in the same manner as in Preparative Example 1, except that a carbon nanotube layer was formed on the back surface (*i*.*e*., a surface of the p-type silicon layer) of the p-n junction silicon substrate.

### <Preparative Example 3>

A silicon solar cell was produced in the same manner as in Preparative Example 1, except that carbon nanotube layers were formed on both surfaces (*i*.*e*., front and back surfaces) of the p-n junction silicon substrate.

### <Comparative Example 1>

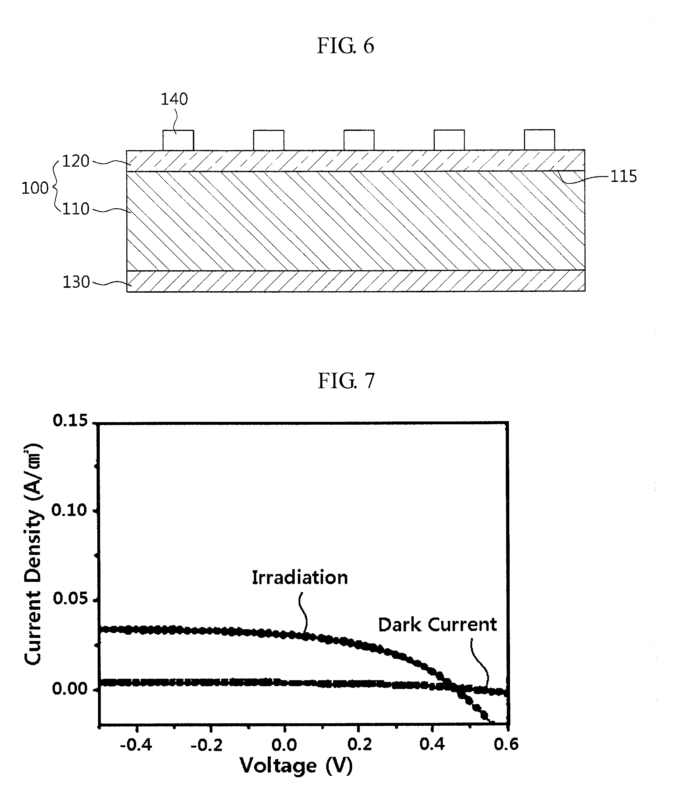

A silicon solar cell was produced in the same manner as in Preparative Example 1, except that no carbon nanotube layer was formed (FIG. 6).

Efficiencies of the silicon solar cells produced in Preparative Examples 1 to 3, which included the carbon nanotube layers, and the silicon solar cell produced in Comparative Example 1, which included no carbon nanotube layer, are shown in FIGS. 7 to 10 and listed in the following Table 1.

In FIGS. 7 to 10, a dark current was obtained by measuring current in the light-free condition, and current on the light was measured at the presence of a light source, which is closest to natural light, using a xenon (Xe) lamp. Here, the light intensity of the xenon lamp was 4 mW/cm², and an air mass (AM) was 1.5.

**[Table 1]**

| | Comparative Example 1 | Preparative Example 1 | Preparative Example 2 | Preparative Example 3 |
|---|---|---|---|---|
| Voltage (V) | 0.46 | 0.47 | 0.47 | 0.47 |
| Current Density (mA/CM²) | 35.1 | 87.1 | 39.9 | 109 |
| Fill Factor (FF) | 0.35 | 0.42 | 0.40 | 0.45 |
| Photoelectric Conversion Efficiency (Eff) (%) | 5.25 | 15.56 | 8.24 | 20.53 |

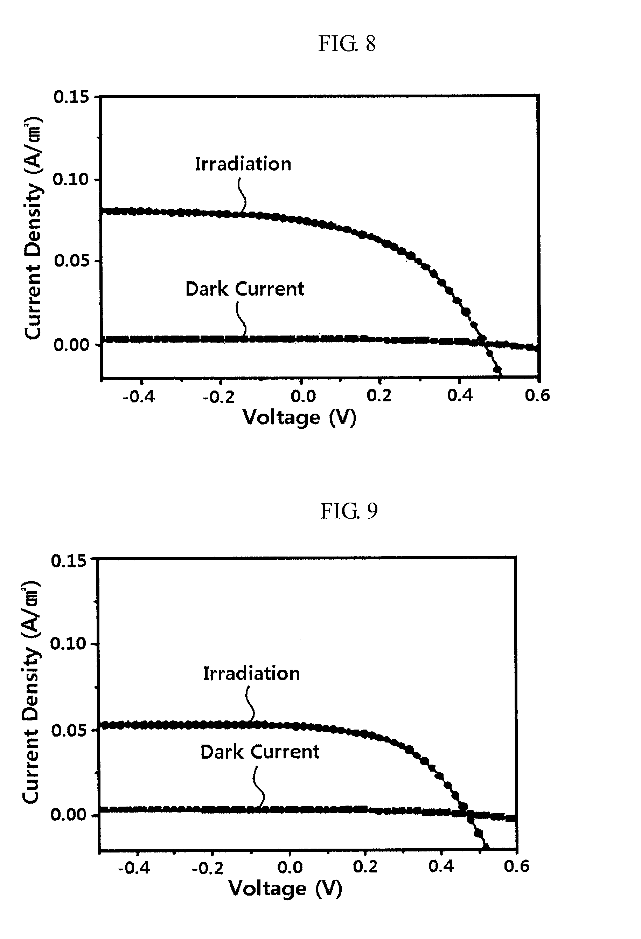

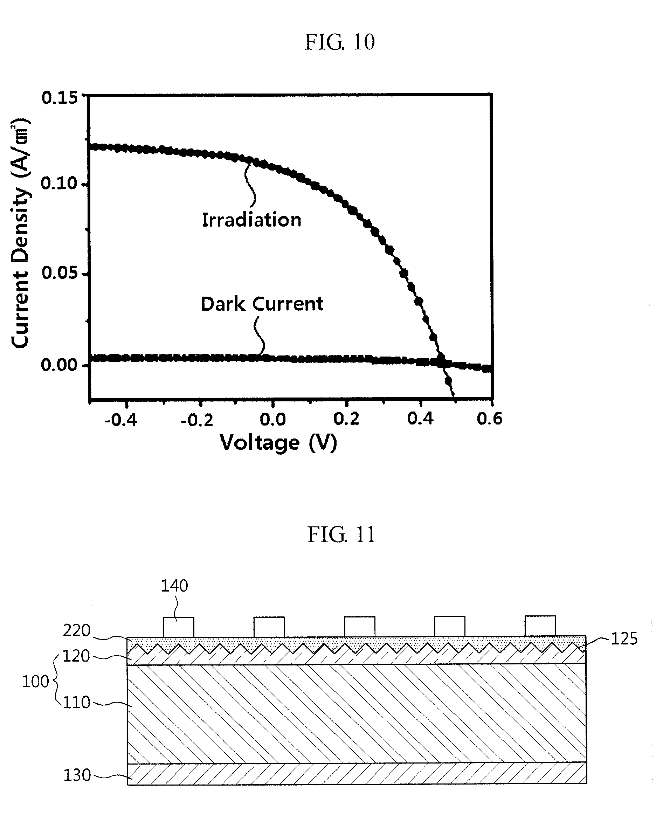

Referring to FIGS. 7 to 10 and Table 1, it was revealed that the silicon solar cells produced in Preparative Example 1 (FIG. 8), Preparative Example 2 (FIG. 9) and Preparative Example 3 (FIG. 10) had highly improved current densities and photoelectric conversion efficiencies, compared to the silicon solar cell produced in Comparative Example 1 (FIG. 7).

Therefore, when the carbon nanotube layer is introduced onto at least one of the front and back surfaces of the p-n junction silicon substrate, it is possible to improve the photoelectric conversion efficiency of the silicon solar cell. In particular, when the carbon nanotube layers are introduced onto both surfaces of the p-n junction silicon substrate (Preparative Example 3), it was revealed that the silicon solar cell had the highest efficiency.

### <Preparative Example 4>

A p-type silicon wafer (specific resistance: 1 to 10 Ωcm, thickness: 500 µm, doping density: 2.5 × 10¹⁵ ions/cm³, and orientation: 100) was prepared, and soaked in a 50% HF solution for 10 seconds to remove a natural oxide film on the silicon wafer. An etching solution obtained by mixing a 4M KOH solution with isopropyl alcohol (IPA) at a volume ratio of 14:1 was put into a thermostat. Then, the silicon wafer was added to the etching solution, and subjected to an anisotropic wet etching process at 80 °C for 10 minutes, thereby forming a concavo-convex structure on a surface of the p-type silicon wafer.

Next, the POCl₃ diffusion process of forming a p-n junction, the process of forming a carbon nanotube layer on a front surface (*i*.*e*., a surface of the n-type silicon layer), which had a concavo-convex structure formed thereof, of the p-n junction silicon substrate, and the process of forming front and back electrodes were performed in the same manner as in Preparative Example 1.

Accordingly, a silicon solar cell was produced, which included a carbon nanotube layer formed on the front surface (*i*.*e*., a surface of the n-type silicon layer) of the p-n junction silicon substrate having a concavo-convex structure (FIG. 11).

### <Preparative Example 5>

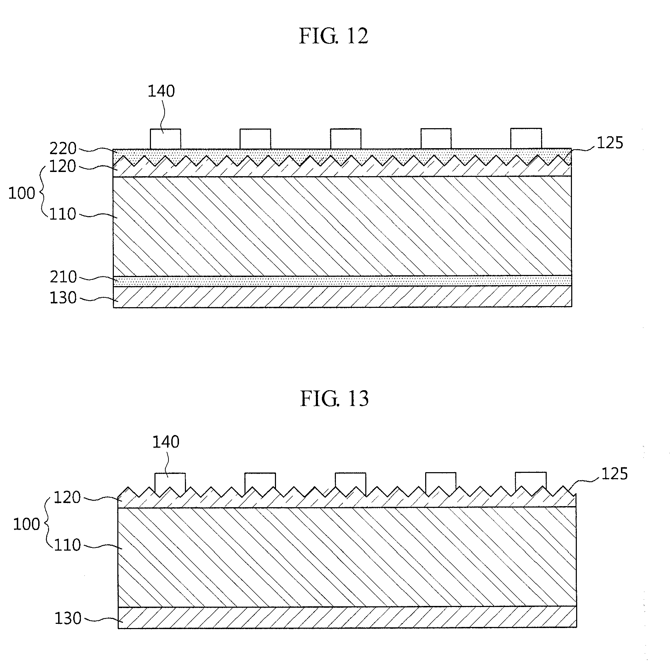

A silicon solar cell was produced in the same manner as in Preparative Example 4, except that a carbon nanotube layers were formed on the front surface (*i*.*e.*, a surface of the n-type silicon layer) of the p-n junction silicon substrate having a concavo-convex structure and the back surface (*i*.*e*., a surface of the p-type silicon layer) of the p-n junction silicon substrate (FIG. 12).

### <Comparative Example 2>

A silicon solar cell was produced in the same manner as in Preparative Example 4, except that no carbon nanotube layer was formed (FIG. 13).

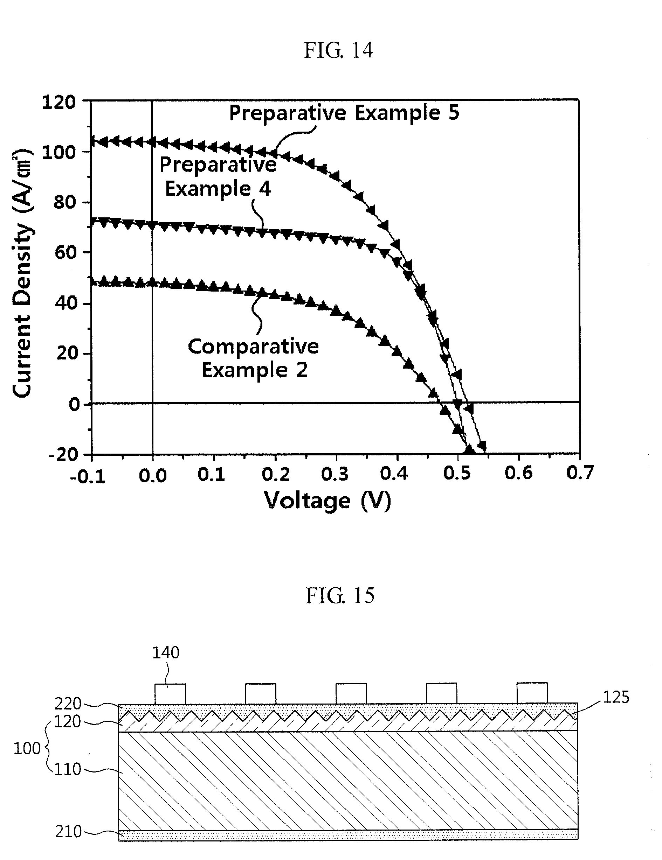

Efficiencies of the silicon solar cells produced in Preparative Examples 4 and 5, which included the carbon nanotube layer, and the silicon solar cell produced in Comparative Example 2, which included no carbon nanotube layer, are shown in FIG. 14 and listed in the following Table 2.

**[Table 2]**

| | Comparative Example 2 | Preparative Example 4 | Preparative Example 5 |
|---|---|---|---|
| Voltage (V) | 0.48 | 0.51 | 0.53 |
| Current Density (mA/cm²) | 49.01 | 74.43 | 105.44 |
| Fill Factor (FF) | 0.53 | 0.64 | 0.72 |
| Photoelectric Conversion Efficiency (Eff) (%) | 9.29 | 15.13 | 22.73 |

Referring to FIG. 14 and Table 2, it was revealed that the silicon solar cells produced in Preparative Examples 4 and 5 had highly improved current densities and photoelectric conversion efficiencies, compared to the silicon solar cell produced in Comparative Example 2.

Therefore, the light absorptance may be increased by the presence of the concavo-convex structure formed on the surface of the p-n junction silicon substrate, and the photoelectric conversion efficiency may be further improved when the carbon nanotube layer is formed on the concavo-convex structure.

### <Preparative Example 6>

A silicon solar cell was produced in the same manner as in Preparative Example 5, except that no back electrode was formed (FIG. 15).

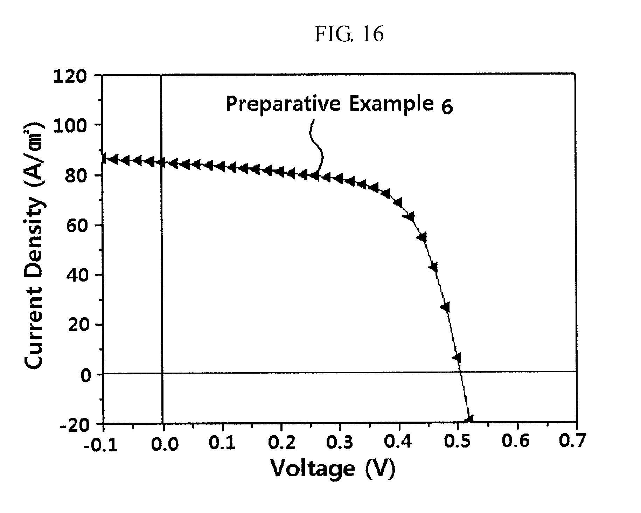

Efficiency of the silicon solar cell produced in Preparative Example 6, which included a carbon nanotube layer but did not include a back electrode, is shown in FIG. 16 and listed in the following Table 3.

**[Table 3]**

| | Preparative Example 6 |
|---|---|
| Voltage (V) | 0.51 |
| Current Density (mA/cm²) | 86.21 |
| Fill Factor (FF) | 0.73 |
| Photoelectric Conversion Efficiency (Eff) (%) | 20.45 |

Referring to FIG. 16 and Table 3, it was seen that the photoelectric conversion efficiency of the silicon solar cell produced in Preparative Example 6 was close to approximately 90% of the photoelectric conversion efficiency of the silicon solar cell produced in Preparative Example 5. That is, it was revealed that, when the carbon nanotube layer was formed on the back surface (*i*.*e*., a surface of the p-type silicon layer) of the p-n junction silicon substrate, the silicon solar cell exhibited high photoelectric conversion efficiency, even when a process of forming a back electrode and a high-temperature heat treatment process for forming a back surface field (*i*.*e*., an RTA process) were omitted. It seems that this is because the carbon nanotube layer formed on the back surface serves as the back electrode, and a BSF effect may be achieved by the presence of the carbon nanotube layer itself.

Meanwhile, although the cases where the back electrode was omitted have been described in these examples, when the carbon nanotube layer was formed on the front surface (*i*.*e*., a surface of the n-type silicon layer) of the p-n junction silicon substrate, the carbon nanotube layer having excellent light transmission and electric conductivity may function on behalf of the front electrode, which makes it possible to omit an additional process of forming a front electrode (*i*.*e*., a metal electrode).

As described above, according to the example embodiments of the present invention, when a carbon nanotube layer is formed on a surface of the p-n junction silicon substrate, the intensity of an electric field applied to the device can be increased. Therefore, it is possible to reduce an electron-hole recombination level and a recombination rate. Also, since a new p-n junction may be formed when the carbon nanotube layer is disposed on the n-type silicon layer, it is possible to realize a multiple exciton generation (MEG) effect, In addition, when the carbon nanotube layer is disposed on the p-type silicon layer, a BSF effect may be achieved by the presence of the carbon nanotube layer itself. Therefore, the photoelectric conversion efficiency of the silicon solar cell may be improved due to introduction of the carbon nanotube layer.

While the example embodiments of the present invention and their advantages have been described in detail, it should be understood that various modifications and variations of the present invention may be made thereto by those skilled in the art without departing from the spirit and scope of the present invention as defined by the appended claims.

### Description of Major Reference Numerals

| | |
|---|---|
| 100: p-n junction silicon substrate | 110: p-type silicon layer |
| 112: back surface | 115: p-n j unction |
| 120: n-type silicon layer | 122: front surface |
| 125: concavo-convex structure | 130: back electrode |
| 140: front electrode | 200: carbon nanotube |
| 210, 220: carbon nanotube layers | |

## Claims

1. A silicon solar cell comprising:
a p-n junction silicon substrate including a p-type silicon layer and an n-type silicon layer;
a carbon nanotube layer disposed on a front or back surface of the silicon substrate;
a first electrode disposed on a surface of the silicon substrate on which the carbon nanotube layer is not disposed.

2. The silicon solar cell of claim 1, further comprising a second electrode disposed on the carbon nanotube layer.

3. The silicon solar cell of claim 1, wherein the surface of the silicon substrate on which the carbon nanotube layer is disposed has a concavo-convex structure.

4. A silicon solar cell comprising:
a p-n junction silicon substrate including a p-type silicon layer and an n-type silicon layer; and
carbon nanotube layers disposed on front and back surfaces of the silicon substrate.

5. The silicon solar cell of claim 4, further comprising an electrode disposed on at least one of the carbon nanotube layers disposed on the front and back surfaces of the silicon substrate.

6. The silicon solar cell of claim 4, wherein at least one of the front and back surfaces of the silicon substrate has a concavo-convex structure.
